# EUROPEAN PATENT SPECIFICATION

(11) **EP 1 973 228 B1**
(45) Date of publication and mention of the grant of the patent: **01.02.2012**
(21) Application number: 06834507.3
(22) Date of filing: 12.12.2006
(51) Int. Cl.: H03H 3/08, H01L 41/09, H01L 41/18, H01L 41/22, H03H 9/25

(54) **METHOD FOR MANUFACTURING SURFACE ACOUSTIC WAVE DEVICE AND SURFACE ACOUSTIC WAVE DEVICE**
VERFAHREN ZUM HERSTELLEN EINES OBERFLÄCHENWELLENBAUELEMENTS UND OBERFLÄCHENWELLENBAUELMENT
DISPOSITIF D'ONDE ACOUSTIQUE DE SURFACE ET SON PROCEDE DE FABRICATION

(30) Priority: 11.01.2006 JP 2006003488
(43) Date of publication of application: 24.09.2008
(73) Proprietor: Murata Manufacturing Co. Ltd., Nagaokakyo-shi, Kyoto 617-8555 (JP)
(72) Inventor: KADOTA, Michio, Nagaokakyo-shi Kyoto 617-8555 (JP); KIMURA, Tetsuya, Nagaokakyo-shi Kyoto 617-8555 (JP)
(74) Representative: Thévenet, Jean-Bruno
(86) International application number: PCT/JP2006/324752
(87) International publication number: WO 2007/080734

(56) References cited:
- JP-A- 06 045 866
- JP-A- 07 115 343
- JP-A- 09 083 030
- JP-A- 10 163 797
- JP-A- 10 163 797
- JP-A- 11 112 282
- JP-A- 56 064 509
- JP-A- 2001 345 673
- US-A- 4 993 000
- TANSKI WILLIAM J: "A CONFIGURATION AND CIRCUIT ANALYSIS FOR ONE-PORT SAW RESONATORS." JOURNAL OF APPLIED PHYSICS APR LNKD- DOI:10.1063/1.325064, vol. 49, no. 4, April 1978 (1978-04), pages 2559-2560, XP002577051

## Description

### Technical Field

The present invention relates to a method for manufacturing a surface-acoustic-wave device that is used as a surface-acoustic-wave resonator or a surface-acoustic-wave filter which utilizes a surface-acoustic wave, such as Rayleigh wave, Love wave, or Leaky wave, and a surface-acoustic-wave device. More particularly, the present invention relates to a method, in which a step of forming an air gap in a portion in which a surface-acoustic wave is excited is improved, for manufacturing a surface-acoustic-wave device, and a surface-acoustic-wave device.

### Background Art

In the related art, the miniaturization of mobile communication equipment, such as mobile phones, has been strongly demanded. For this reason, the miniaturization of band-pass filters used in this type of communication equipment has been demanded.

As compact band-pass filters, in the related art, surface-acoustic-wave filters that utilize surface-acoustic-waves have been commonly used. In Patent Document 1 described below, a surface-acoustic-wave-filter device capable of being miniaturized is disclosed.

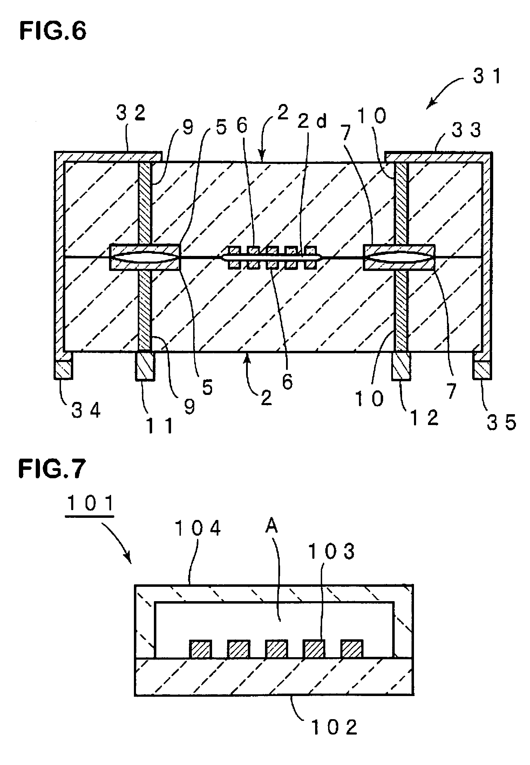

As shown in Fig. 7, in a method for manufacturing a surface-acoustic-wave device 101 that is disclosed in Patent Document 1, first, a piezoelectric substrate 102 is prepared. On the top surface of the piezoelectric substrate 102, electrodes such as IDT electrodes 103 are formed to configure a surface-acoustic-wave filter. The IDT electrodes 103 are formed in a portion of the piezoelectric substrate. The portion of the piezoelectric substrate is excited when the surface-acoustic-wave filter is used, and a surface-acoustic wave is propagated. Accordingly, it is necessary to form an air gap A that the IDT electrodes 103 face. For this reason, as shown in Fig. 7, a cover member 104 is bonded to the piezoelectric substrate 102 so that the cover member 104 can cover the top surface of the piezoelectric substrate 102 and so that the air gap A can remain.

In the manufacturing method disclosed in Patent Document 1, the bonding of the cover member 104 is performed by direct bonding without using an adhesive. The direct bonding is a method in which heat is applied to the piezoelectric substrate 102 and the cover member 104 in a state in which the piezoelectric substrate 102 is in contact with the cover member 104 to make hydrogen bonds therebetween, thereby directly bonding the piezoelectric substrate 102 and the cover member 104 together. Accordingly, it is necessary that surfaces of portions facing the surfaces of the piezoelectric substrate 102 and the cover member 104 which are to be bonded have hydrophilic groups. The hydrophilic groups are to be bonded by means of hydrogen bonds of water molecules provided from moisture or the like.

Because the bonding is performed by the direct bonding, no adhesive is needed to be used. A sealing property of portions of the cover member 104 and the piezoelectric substrate 102 to be bonded can be increased.

JP 10-163797 describes a surface acoustic wave device in which an IDT electrode is provided in a recess in the piezoelectric substrate. An insulating cover member covers the recess and has through-holes provided therein (for connector electrodes).

SAW devices having recessed IDT electrodes are also described in JP 56-064509 and in "A Configuration and Circuit Analysis for One-Port SAW Resonators" by William J. Tanski (Database Compendex, Engineering information Inc., New York, database accession number EIX7809008188)
Patent Document 1: Japanese Unexamined Patent Application Publication No. 7-115343

### Disclosure of Invention

Because, in the surface-acoustic-wave-filter device 101 disclosed in Patent Document 1, it is necessary to form the air gap A, the size of the entire package needs to be increased.

Additionally, a recessed portion used to form the air gap A needs to be formed in the cover member 104, or the cover member 104 having a recessed portion needs to be prepared. Accordingly, there is also a problem that the cost is high.

It is an object of the present invention to provide a surface-acoustic-wave device which is free from the above-described disadvantages in the related art, which does not need a complicated processing step, which does not need preparation of a component such as a cover member having a complicated shape, which is inexpensive, and which is capable of increasing miniaturization, and a method for manufacturing the surface-acoustic-wave device.

A method for manufacturing a surface-acoustic-wave device according to the present invention includes the following: a step of preparing a piezoelectric substrate and a cover member; a step of forming, in one principal surface of the piezoelectric substrate, grooves in portions in which an IDT electrode and a wiring electrode are to be provided; a step of forming, on the one principal surface of the piezoelectric substrate, a metallic film at least in the grooves; a step of forming a recessed portion on the metallic film in the grooves and on a portion of the piezoelectric substrate in the vicinity of the grooves by removing one portion of the piezoelectric substrate from the principal surface side of the piezoelectric substrate to form, using the metallic film positioned in the grooves, the IDT electrode and the wiring electrode; and a step of bonding the cover member to the one principal surface of the piezoelectric substrate.

In a specific aspect of the method for manufacturing a surface-acoustic-wave device according to the present invention, the step of forming the recessed portion is performed by performing a CMP process from the one principal surface side of the piezoelectric substrate.

In another specific aspect of the method for manufacturing a surface-acoustic-wave device according to the present invention, the step of forming the recessed portion is performed by dry etching while a mask is being applied to the one principal surface of the piezoelectric substrate.

In a further specific aspect of the method for manufacturing a surface-acoustic-wave device according to the present invention, the step of bonding the cover member to the piezoelectric substrate is performed by direct bonding.

In a more specific aspect of the method for manufacturing a surface-acoustic-wave device according to the present invention, when the piezoelectric substrate and the cover member are to be directly bonded together, a hydrophilic insulating thin film is formed on the one principal surface of the piezoelectric substrate and/or a surface of the cover member that is to be bonded to the piezoelectric substrate.

In a further aspect of the method for manufacturing a surface-acoustic-wave device according to the present invention, the method further includes a step of forming, in the piezoelectric substrate, a through-hole electrode that is to be connected to the wiring electrode.

In a further aspect of the method for manufacturing a surface-acoustic-wave device according to the present invention, the method further includes a step of forming, in the cover member, a through-hole electrode that is to be electrically connected to the wiring electrode.

In a further aspect of the method for manufacturing a surface-acoustic-wave device according to the present invention, as the cover member, a piezoelectric substrate in one principal surface of which an IDT electrode and a wiring electrode are formed as in the case of the piezoelectric substrate is used.

A surface-acoustic-wave device according to the present invention includes the following elements: a piezoelectric substrate in one principal surface of which a recessed portion is formed, and in which a groove having a shape corresponding to a shape of an IDT electrode is formed in the recessed portion; an IDT electrode embedded in the groove; a cover member bonded to the one principal surface of the piezoelectric substrate; a through-hole electrode that is provided in the piezoelectric substrate, and that is electrically connected to the IDT electrode; and a terminal electrode that is provided in the piezoelectric substrate, that is electrically connected to the through-hole electrode, and that is disposed so as to be electrically connected to an external device.

In an aspect of the surface-acoustic-wave device according to the present invention, a groove having a shape corresponding to a shape of a wiring electrode is formed in the one principal surface of the piezoelectric substrate at a position different from that of the recessed portion, and the wiring electrode is embedded in the groove.

### (Advantages of Invention)

In the method for manufacturing a surface-acoustic-wave device according to the present invention, the grooves are formed in the one principal surface of the piezoelectric substrate. After that, the metallic film is formed at least in the grooves, and then one portion of the piezoelectric substrate is removed from the principal surface side of the piezoelectric substrate to form the recessed portion. By forming the recessed portion, the IDT electrode and the wiring electrode are formed of the metallic film positioned in the grooves. In this case, even in a case in which the metallic film extends to the periphery of the grooves, when the recessed portion is formed, the recessed portion is formed so as to remove a portion of the metallic film that is positioned at the periphery of the grooves. Accordingly, in the one principal surface of the piezoelectric substrate, the IDT electrode is formed at a position lower than that of the one principal surface. Thus, for example, even when a cover member having a planar shape is used, by bonding the cover member to the one principal surface, an air gap that the IDT electrode faces can be formed using the recessed portion. Therefore, no cover member having a complicated shape is necessary. Additionally, no complicated step of forming an air gap in the cover member is necessary.

When the recessed portion is formed, the size of the air gap can be highly precisely and easily adjusted, and the air gap can be formed by forming the recessed portion. Accordingly, miniaturization can be increased. Thus, the surface-acoustic-wave device that is inexpensive and miniaturized can be provided.

When the recessed portion is formed by performing a CMP process from the one principal surface side of the piezoelectric substrate, the recessed portion can be highly precisely and easily formed without degradation of the piezoelectric substrate.

When the recessed portion is formed by dry etching while a mask is being applied, the recessed portion can be easily formed only by preparing a mask having a shape corresponding to a planar shape of the recessed portion and performing the dry etching.

When the step of bonding the cover member is performed by direct bonding, no agglutinant such as an adhesive is necessary. Accordingly, the cost can be reduced. Additionally, when the cover member is bonded to the piezoelectric substrate by the direct bonding, a low profile can be enhanced. Furthermore, the surface-acoustic-wave device can be provided, in which a variation in bonded portion is difficult to occur, in which a variation in characteristics is small, and which has an excellent reliability.

When the piezoelectric substrate and the cover member are directly bonded together, a hydrophilic insulating thin film may be formed on the one principal surface of the piezoelectric substrate and/or the surface of the cover member that is to be bonded to the piezoelectric substrate. In such a case, even when the piezoelectric substrate or the cover member does not have hydrophilic groups on the surface thereof, by forming the hydrophilic insulating thin film, the piezoelectric substrate and the cover member can assuredly be bonded together by the direct bonding.

When the method further includes the step of forming, in the piezoelectric substrate, a through-hole electrode that is to be connected to the wiring electrode, the wiring electrode can be, for example, connected to an external device via the through-hole electrode. Similarly, when the method further includes the step of forming, in the cover member, a through-hole electrode that is to be electrically connected to the wiring electrode, the wiring electrode can be easily electrically connected to, for example, an external device via the through-hole electrode.

When, as the cover member, a piezoelectric substrate having a configuration in which an IDT electrode and a wiring electrode are formed on one principal surface thereof as in the case of the piezoelectric substrate is used, a surface-acoustic-wave device in which two surface-acoustic-wave elements are stacked can be provided in accordance with the present invention. Accordingly, electronic equipment or a circuit in which the surface-acoustic-wave device is mounted can be miniaturized and designed at a high density.

In the surface-acoustic-wave device according to the present invention, the recessed portion is formed in the one principal surface of the piezoelectric substrate. The groove having a shape corresponding to a shape of a portion in which an IDT electrode is to be formed is formed in the recessed portion, and the IDT electrode is formed so as to be embedded in the groove. Accordingly, in a configuration in which the cover member is bonded to the one principal surface of the piezoelectric substrate, an air gap can be formed, which does not prevent the IDT electrode from vibrating in the recessed portion. Thus, the miniaturization of the surface-acoustic-wave device can be increased. Furthermore, because the air gap is formed using the recessed portion, a cover member having a planar shape can be used, thereby reducing the cost of the cover member.

The through-hole electrode may be provided in the piezoelectric substrate, and the terminal electrode that is electrically connected to the through-hole electrode and that is disposed so as to be electrically connected to an external device may be provided. In such a case, the IDT electrode can be easily electrically connected to the external device via the through-hole electrode and the terminal electrode.

Accordingly, the surface-acoustic-wave device can be obtained, which is miniaturized, inexpensive, and capable of being easily mounted on a printed circuit board.

The groove having a shape corresponding to a shape of a wiring electrode may be formed in the one principal surface of the piezoelectric substrate at a position different from that of the recessed portion, and the wiring electrode may be embedded in the groove. In such a case, the wiring electrode can be formed by a step the same as that of forming the IDT electrode. The surface-acoustic-wave device can be miniaturized, and the cost thereof can be reduced.

### Brief Description of Drawings

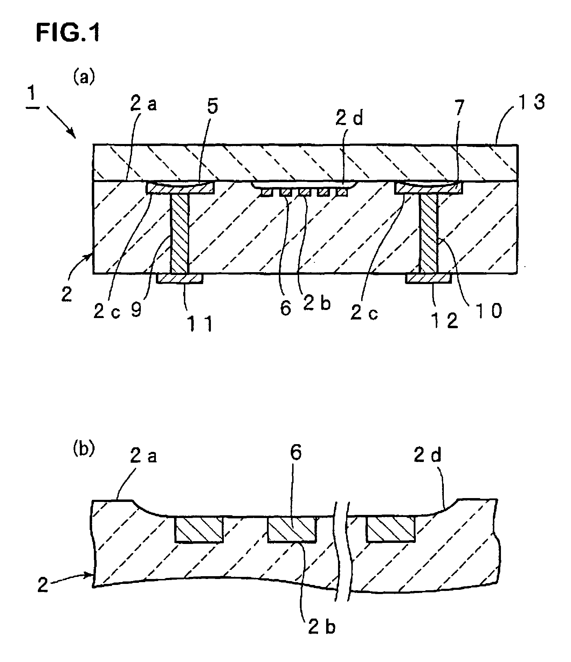

Parts (a) and (b) of Fig. 1 are a front sectional view of a surface-acoustic-wave-filter device according to an embodiment of the present invention and a partial enlarged front sectional view of the surface-acoustic-wave-filter device, describing the main portion of the surface-acoustic-wave-filter device.

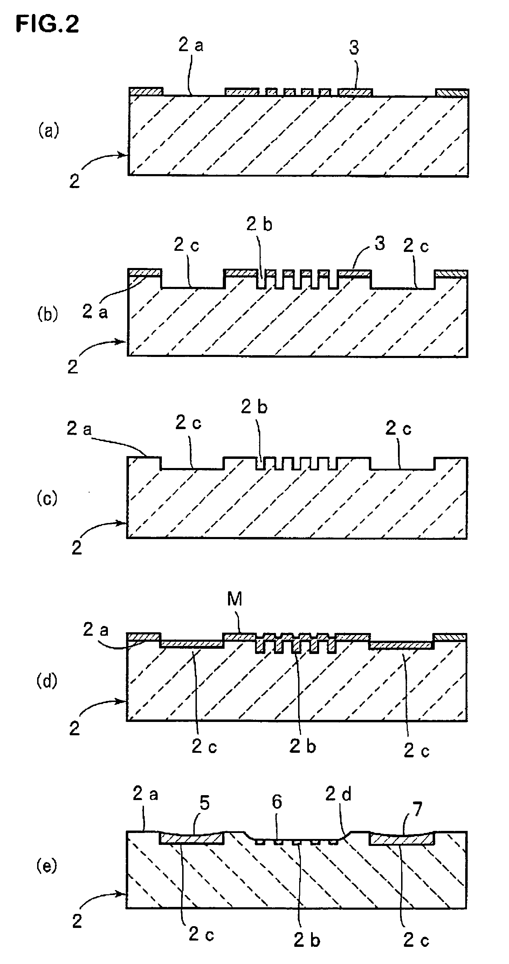

Parts (a) to (e) of Fig. 2 are schematic front sectional views of the surface-acoustic-wave-filter device according to the embodiment of the present invention, describing a method for manufacturing the surface-acoustic-wave-filter device.

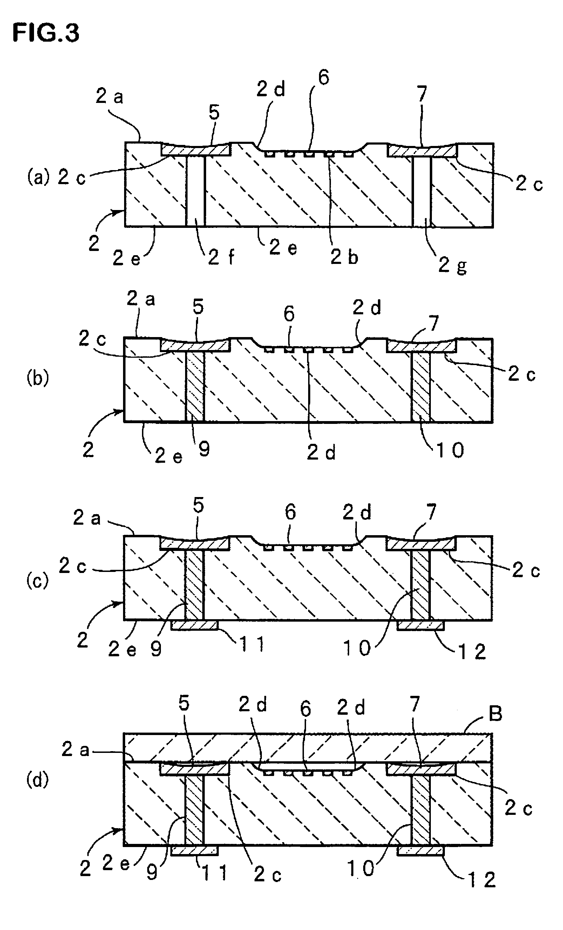

Parts (a) to (d) of Fig. 3 are schematic front sectional views of the surface-acoustic-wave-filter device according to the embodiment of the present invention, describing the method for manufacturing the surface-acoustic-wave-filter device.

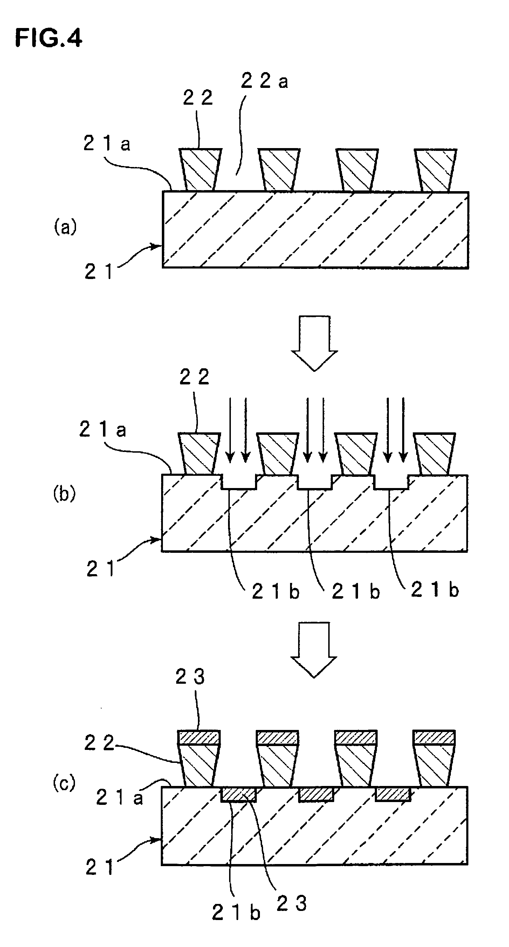

Parts (a) to (c) of Fig. 4 are schematic front sectional views of a recessed portion, describing a modification example in which the recessed portion is formed by dry etching.

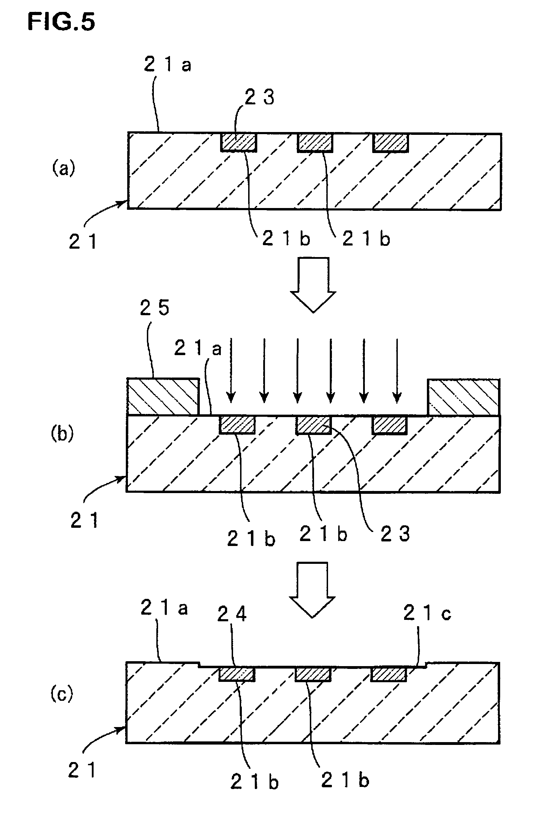

Parts (a) to (c) of Fig. 5 are schematic front sectional views of the recessed portion, describing the modification example in which the recessed portion is formed by dry etching.

Fig. 6 is a front sectional view of a surface-acoustic-wave-filter device according to another embodiment of the present invention.

Fig. 7 is a front sectional view of a surface-acoustic-wave-filter device in the related art, describing an example of the surface-acoustic-wave-filter device. Reference Numerals
- 1: surface-acoustic-wave-filter device
- 2: piezoelectric substrate
- 2a: top surface (one principal surface)
- 2b: grooves
- 2c: grooves
- 2d: recessed portion
- 2e: bottom surface
- 2f, 2g: through holes
- 3: mask
- 6: IDT electrodes
- 5, 7: wiring electrodes
- 9, 10: through-hole electrodes
- 11, 12: terminal electrodes
- 13: cover member
- 21: piezoelectric substrate
- 21a: top surface (one principal surface)
- 21b: grooves
- 21c: recessed portion
- 22: mask
- 23: metallic film
- 24: IDT electrodes
- 25: mask
- 31: surface-acoustic-wave-filter device
- 32, 33: terminal electrodes
- 34, 35: terminal electrodes
- A: gap

### Best Mode for Carrying Out the Invention

Specific embodiments of the present invention will be described below with reference to the drawings, whereby the present invention will become apparent.

Parts (a) and (b) of Fig. 1 are a front sectional view of a surface-acoustic-wave-filter device according to an embodiment of the present invention and a partial enlarged front sectional view of the surface-acoustic-wave-filter device, showing the enlarged main portion of the surface-acoustic-wave-filter device. A method for manufacturing a surface-acoustic-wave-filter device 1 according to the embodiment will be described with reference to parts (a) to (e) of Fig. 2 and parts (a) to (d) of Fig. 3.

First, as shown in part (a) of Fig. 2, a piezoelectric substrate 2 is prepared. The piezoelectric substrate 2 may be formed of a piezoelectric single crystal or a piezoelectric ceramic. In this embodiment, the piezoelectric substrate 2 is formed of crystal. On a top surface 2a serving as one principal plane of the piezoelectric substrate 2, a mask 3 is formed using a photolithography technique. The resist mask 3 has openings as portions in which IDT electrodes and wiring electrodes are to be formed. Instead of using the resist mask 3, a metallic mask formed of Ni, Cr, or the like may be used.

Next, as shown in part (b) of Fig. 2, portions of the piezoelectric substrate facing the openings of the resist mask 3 are removed using an etching method to form grooves 2b, 2c, and 2c. The grooves 2b have a planar shape corresponding to a planar shape in which the IDT electrodes are to be formed. The grooves 2c and 2c are provided in portions in which the wiring electrodes are to be formed.

When the etching is performed, an appropriate etchant that does not dissolve the resist mask 3 can be used. When the piezoelectric substrate 2 is formed of crystal, a fluoride gas, such as CF₄ or SF₆, or a chloride gas, such as BCl₃, may be used as the etchant. When the piezoelectric substrate 2 is formed of LTaO₃ or LiNbO₃, a fluoride gas, Ar, or the like may be used as a gas for etching.

Next, the resist mask 3 is dissolved and removed using a resist removal liquid. In this manner, as shown in part (c) of Fig. 2, the piezoelectric substrate 2 in the top surface 2a of which the grooves 2b, 2c, and 2c are formed is prepared.

Then, as shown in part (d) of Fig. 2, a metallic film M is formed on the entire top surface 2a of the piezoelectric substrate 2 using an appropriate thin-film forming method, such as vapor deposition, sputtering, or plating. Because the metallic film M serves as an electrode constituent material, the metallic film M can be formed of an appropriate metallic material. For example, the metallic film M may be formed of Al, Cu, Au, Ta, or W, an alloy of Al, Cu, Au, Ta, or W, or stacked metallic films formed of two or more types of metals chosen from among Al, Cu, Au, Ta, and W.

After that, as shown in part (e) of Fig. 2, by a CMP process, a portion of the top surface 2a of the piezoelectric substrate is removed from the top surface 2a side of the piezoelectric substrate 2 to form a recessed portion 2d. The recessed portion 2d is formed so that the above-described grooves 2b are positioned in the recessed portion 2d, i.e., so that a region in which the IDT electrodes are to be formed is positioned in the recessed portion 2d. When the CMP process is performed, the recessed portion 2d is formed, and a portion of the metallic film that is positioned at the periphery of a portion in which the IDT electrodes 6 are formed is removed. Additionally, wiring electrodes 5 and 7 are formed of the metallic film that remains in the recessed portions 2c and 2c. A process of removing the portion of the top surface 2a of the piezoelectric substrate 2 by the CMP process is performed so that the metallic film excluding the portions in which the IDT electrodes 6 and the wiring electrodes 5 and 7 are formed can be removed. Accordingly, the IDT electrodes 6 are embedded in the grooves 2b. Similarly, the wiring electrodes 5 and 7 are embedded in the grooves 2c and 2c, respectively.

The CMP (chemical mechanical polishing) process is commonly used as a polishing method used in, for example, a case in which an interlayer-insulating film of a semiconductor device is formed. In the CMP process, when polishing is performed by a polishing head, a polishing liquid is supplied. The CMP process is a process in which mechanical polishing performed by the polishing head and chemical polishing using the polishing liquid are performed together.

The conditions of the CMP process can be appropriately set in accordance with the piezoelectric substrate 2 to be used, the depth and size of the recessed portion 2d to be formed, and so forth, and are not particularly limited. However, in this embodiment, for example, the CMP process may be performed by applying a polishing pressure of approximately 100 g/cm² using a polishing pad, which is configured using IC1000 manufactured by Nitta Haas, rotating at several tens rpm to several hundred rpm, and simultaneously by supplying a polishing liquid. The polishing liquid, for example, is obtained by diluting one part of Planerlite 7102, which is manufactured by Fujimi Incorporated, with five parts of pure water.

When the above-described CMP process is performed, the recessed portion 2d is formed due to an effect of erosion. The internal surface of the recessed portion 2d is formed as a curved surface around the edges of the recessed portion 2d. Additionally, the surface of the metallic film filling the grooves 2c is curved due to an effect of dishing as shown in part (e) of Fig. 2. In other words, since the central portions are polished more than the edge portions, the top surfaces of the wiring electrodes 5 and 7 are curved.

Next, as shown in part (a) of Fig. 3, through holes 2f and 2g are formed, which are used to form through-hole electrodes so that the through-hole electrodes can extend to the wiring electrodes 5 and 7 formed in the top surface 2a from a bottom surface 2e of the piezoelectric substrate 2. The process of forming the through holes 2f and 2g is not particularly limited. However, the through holes 2f and 2g can be formed using an appropriate processing method in which a laser or sandblasting is used. For example, a mask is formed on the bottom surface 2e of the piezoelectric substrate 2, and the mask has openings as portions in which the through holes 2f and 2g are to be formed. By performing a sandblasting process, the through holes 2f and 2g can be formed.

Then, as shown in part (b) of Fig. 3, the through holes 2f and 2g are filled with a metallic material, for example, by plating, thereby forming through-hole electrodes 9 and 10.

After that, as shown in part (c) of Fig. 3, terminal electrodes 11 and 12 are formed on the bottom surface 2e of the piezoelectric substrate 2 so that the terminal electrodes 11 and 12 can be electrically connected to the through-hole electrodes 9 and 10, respectively. The terminal electrodes 11 and 12 can be formed using an appropriate method such as plating or printing of metal bumps.

Then, as shown in part (d) of Fig. 3, a cover member 13 having a planar shape is bonded to the top surface of the piezoelectric substrate 2. In this case, for the cover member 13, an appropriate insulating material such as crystal, glass, or an Si-based material may be used. Preferably, the cover member 13 has hydrophilic groups on the surface thereof.

After that, by direct bonding, the cover member 13 is bonded to the top surface 2a of the piezoelectric substrate 2. The direct bonding can be performed by, for example, application of heat at 200 °C to 400 °C for about one hour. As disclosed in Patent Document 1, which is described above, the direct bonding is a method in which the cover member 13 and the piezoelectric substrate 2 are bonded together by means of hydrogen bonds without using an agglutinant such as an adhesive.

In other words, in a case in which hydrophilic groups exist on surfaces of the piezoelectric substrate 2 and the cover member 13 that are to be bonded, when heat is applied, water molecules supplied from moisture in the atmosphere or the like are bonded to the hydrophilic groups. Accordingly, the piezoelectric substrate 2 and the cover member 13 are bonded together by means of hydrogen bonds.

Before the direct bonding is performed, the surface of the piezoelectric substrate 2 may be immersed in a liquid mixture of ammonia and hydrogen peroxide in advance, thereby performing a process of causing the surface to be hydrophilic.

When the surfaces of the cover member 13 and the piezoelectric substrate 2 do not have hydrophilic groups, preferably, a hydrophilic insulating thin film may be formed on the surface of the piezoelectric substrate 2 and/or the surface of the cover member 13 to be bonded.

By using the direct bonding method, in the entire region of portions at which the cover member and the piezoelectric substrate 2 are in contact with each other and bonded together, the cover member 13 and the piezoelectric substrate 2 are strongly bonded together. Accordingly, the recessed portion 2d that the portion in which the IDT electrodes are formed faces can be airtightly sealed assuredly and strongly. The reliability of the surface-acoustic-wave device can also be increased.

In the embodiment, when, for adjustment of temperature characteristics or frequency characteristics, a dielectric film of SiO₂, SiN, or the like is provided on the IDT electrodes, the dielectric film may be provided over the entire surface of the piezoelectric substrate. In this case, after a process of causing the dielectric film to be hydrophilic is appropriately performed, the direct bonding is performed.

In this manner, the surface-acoustic-wave-filter device 1 shown in parts (a) and (b) of Fig. 1 can be obtained.

As clearly shown in parts (a) and (b) of Fig. 1, in this embodiment, the recessed portion 2d is formed by the CMP process, thereby providing an air gap that the IDT electrodes 6 face. Accordingly, the cover member 13 having a planar shape, i.e., a cover member at least the bottom surface of which has a planar shape, can be used. It is not necessary that a cover member having a complicated shape is prepared. It is also not necessary a complicated process is performed on the cover member. Thus, the cost of the surface-acoustic-wave-filter device 1 can be reduced.

Additionally, by adjusting process conditions in which the CMP process is performed, the recessed portion 2d can be highly precisely and easily formed. Accordingly, the depth of the recessed portion 2d can also be made small. Thus, the surface-acoustic-wave-filter device 1 can be minimized. More specifically, a low profile can be achieved.

Furthermore, the bonding is performed by the direct bonding, and no adhesive is used. Accordingly, characteristic deterioration caused by a variation in bonded portion is difficult to occur. The low profile can also be enhanced.

In this embodiment, the wiring electrodes are connected to the terminal electrodes via the through-hole electrodes. However, without providing the through-hole electrodes, the wiring electrodes may be electrically connected to the terminal electrodes via wiring patterns that are provided on the external surface of the piezoelectric substrate.

Furthermore, the through-hole electrodes may be provided in the cover member 13 side, instead of being provided in the piezoelectric substrate side.

In the embodiment, the recessed portion 2d is formed by the CMP process, whereby the air gap that the IDT electrodes face is formed. However, in the present invention, a dry etching method may be used when a recessed portion that faces IDT is formed. The IDT electrodes face the recessed portion. As a modification example, a method for forming the recessed portion using the dry etching method will be described with reference to parts (a) to (c) of Fig. 4 and parts (a) to (c) of Fig. 5.

In the modification example, as schematically shown in part (a) of Fig. 4, a mask 22 is formed on a top surface 21a of a piezoelectric substrate 21. The mask 22 has openings 22a as portions in which IDT electrodes and wiring electrodes (not shown) are to be formed.

In other words, as shown in part (b) of Fig. 4, grooves 21b are formed in the top surface 21a serving as one principal plane of the piezoelectric substrate 21 using the dry etching method. The grooves 21b have a planar shape corresponding to a planar shape of the IDT electrodes.

After that, as shown in part (c) of Fig. 4, a metallic film 23 used to form the IDT electrodes is provided over the entire surface, thereby filling the grooves 21b with the metallic film to form the metallic film 23 used as the IDT electrodes.

Then, the mask 22 and the metallic film 23, which is stacked on the mask 22, are removed using a lift-off method using a solvent that removes the mask 22. In this manner, as shown in part (a) of Fig. 5, the piezoelectric substrate 21 can be obtained, which has the metallic film 23 used as the IDT electrodes that are embedded in the grooves 21b.

The mask 22 may be formed of a material similar to that of the resist mask 3 or the metallic film M in the forgoing embodiment. Additionally, regarding the method for forming the grooves 21b by dry etching, the method can be implemented by performing dry etching using an appropriate etchant in accordance with the material of the piezoelectric substrate 21.

Next, as shown in part (b) of Fig. 5, another mask 25 is disposed on the top surface 21a of the piezoelectric substrate 21. The mask 25 has an opening as a portion including a portion in which the metallic film 23 used as the IDT electrodes is formed. In the state in which the mask 25 is disposed, one portion of the top surface 21a of the piezoelectric substrate 21 and the upper portion of the metallic film 23 used as the IDT electrodes are removed using the dry etching method to form a recessed portion 21c. After that, the mask 25 is removed by a solvent. In this manner, as shown in part (c) of Fig. 5, the piezoelectric substrate 21 that has the recessed portion 21c in the top surface 21a can be obtained. In the recessed portion 21c, IDT electrodes 24 are disposed.

Figs. 4 and 5 schematically show only the method for manufacturing a portion in which the IDT electrodes 24 are to be formed. However, a portion in which the wiring electrodes are to be formed is also simultaneously formed in the same manner. After the recessed portion 21c is formed as shown in part (c) of Fig. 5, through-hole electrodes, terminal electrodes, and so forth are formed as in the case of the forgoing embodiment, and then a cover member is bonded. In this manner, a surface-acoustic-wave-filter device can be obtained.

Fig. 6 is a front sectional view of a surface-acoustic-wave-filter device according to further another embodiment of the present invention. In the surface-acoustic-wave-filter device 1 shown in Fig. 1, the cover member 13 is bonded to the top surface 2a of the piezoelectric substrate 2. However, in a surface-acoustic-wave-filter device 31 shown in Fig. 6, another upside-down piezoelectric substrate 2 is stacked on the top surface of the piezoelectric substrate 2, and bonded by direct bonding. In other words, instead of using the cover member 13 according to the first embodiment, another piezoelectric substrate 2 having a configuration similar to that of the piezoelectric substrate 2 is used. The principal planes of the pair of the piezoelectric substrates 2 and 2 in which the IDT electrodes 6 are formed are stacked together, and the pair of the piezoelectric substrates 2 and 2 are bonded together by the direct bonding.

Accordingly, in this embodiment, a stacked-type surface-acoustic-wave-filter device 31 is formed, in which two surface-acoustic-wave-filter elements are stacked.

On the top surface of the upper piezoelectric substrate 2, terminal electrodes 32 and 33 that are connected to the through-hole electrodes 9 and 10, respectively, are formed. The terminal electrodes 32 and 33 extend to the bottom surface of the lower piezoelectric substrate via the side faces of the stacked-type device in which the piezoelectric substrates 2 and 2 are stacked. On the bottom surface of the lower piezoelectric substrate 2, terminal electrodes 34 and 35 that are connected to terminal electrodes 32 and 33, respectively, are formed. Accordingly, the surface-acoustic-wave-filter device 31 can be easily surface-mounted on a circuit board or the like using the terminal electrodes 34 and 35 and the terminal electrodes 11 and 12.

As it is clear in the embodiment, in the present invention, the cover member does not necessarily serve as a casing material always. The cover member may serve as an electronic component element.

## Claims

1. A method for manufacturing a surface-acoustic-wave device (1) comprising:
a step of preparing a piezoelectric substrate (2) and a cover member (13);
a step of forming, in one principal surface (2a) of the piezoelectric substrate (2), grooves (2b,2c) in portions in which an IDT electrode (6) and a wiring electrode (5,7) are to be provided;
a step of forming, on the one principal surface (2a) of the piezoelectric substrate, a metallic film (M) at least in the grooves (2b,2c);
a step of forming a recessed portion (2d) on the metallic film (M) in the grooves (2b) and on a portion of the piezoelectric substrate in the vicinity of the grooves (2b) by removing one portion of the piezoelectric substrate from the principal surface side (2a) of the piezoelectric substrate to form, using the metallic film positioned in the grooves, the IDT electrode (6) and the wiring electrode (5,7) ; and
a step of bonding the cover member (13) to the one principal surface (2a) of the piezoelectric substrate.

2. The method for manufacturing a surface-acoustic-wave device according to Claim 1, wherein the step of forming the recessed portion (2d) is performed by performing a CMP process from the one principal surface side (2a) of the piezoelectric substrate.

3. The method for manufacturing a surface-acoustic-wave device according to Claim 1, wherein the step of forming the recessed portion (21c) is performed by dry etching while a mask (25) is being applied to the one principal surface of the piezoelectric substrate.

4. The method for manufacturing a surface-acoustic-wave device according to any one of Claims 1 to 3, wherein the step of bonding the cover member (13) to the piezoelectric substrate (2) is performed by direct bonding.

5. The method for manufacturing a surface-acoustic-wave device according to Claim 4, wherein, when the piezoelectric substrate (2) and the cover member (13) are to be directly bonded together, a hydrophilic insulating thin film is formed on the one principal surface of the piezoelectric substrate (2a) and/or a surface of the cover member (13) that is to be bonded to the piezoelectric substrate.

6. The method for manufacturing a surface-acoustic-wave device according to any one of Claims 1 to 5, further comprising a step of forming, in the piezoelectric substrate, a through-hole electrode (9,10) that is to be connected to the wiring electrode (5,7).

7. The method for manufacturing a surface-acoustic-wave device according to any one of Claims 1 to 6, further comprising a step of forming, in the cover member (13), a through-hole electrode that is to be electrically connected to the wiring electrode (5,7).

8. The method for manufacturing a surface-acoustic-wave device according to any one of Claims 1 to 7, wherein, as the cover member, a piezoelectric substrate (2) in one principal surface of which an IDT electrode (6) and a wiring electrode (5,7) are formed as in the case of the piezoelectric substrate is used.

9. A surface-acoustic-wave device (1) comprising:
a piezoelectric substrate (2) in one principal surface (2a) of which a recessed portion (2d) is formed, and in which a groove (2b) having a shape corresponding to a shape of an IDT electrode (6) is formed in the recessed portion (2d);
an IDT electrode (6) embedded in the groove (2b);
a cover member (13) bonded to the one principal surface (2a) of the piezoelectric substrate;
a through-hole electrode (9,10) that is provided in the piezoelectric substrate, and that is electrically connected to the IDT electrode (6); and
a terminal electrode (11,12) that is provided in the piezoelectric substrate, that is electrically connected to the through-hole electrode (9,10), and that is disposed so as to be electrically connected to an external device.

10. The surface-acoustic-wave device according to Claim 9, wherein a groove (2c) having a shape corresponding to a shape of a wiring electrode (5,7) is formed in the one principal surface (2a) of the piezoelectric substrate at a position different from that of the recessed portion (2d), and the wiring electrode (5,7) is embedded in the groove (2c).

## Patentansprüche

1. Verfahren zum Herstellen einer Oberflächenschallwellenvorrichtung (1), umfassend:
einen Schritt des Vorbereitens eines piezoelektrischen Substrats (2) und eines Abdeckelements (13),
einen Schritt des Ausbildens von Rillen (2b, 2c) in einer Hauptoberfläche (2a) des piezoelektrischen Substrats (2) in Abschnitten, in welchen eine IDT-Elektrode (6) und eine Verdrahtungselektrode (5, 7) bereitgestellt werden sollen,
einen Schritt des Ausbildens eines metallischen Films (M) auf der einen Hauptoberfläche (2a) des piezoelektrischen Substrats zumindest in den Rillen (2b, 2c),
einen Schritt des Ausbildens eines vertieften Abschnitts (2d) auf dem metallischen Film (M) in den Rillen (2b) und auf einem Abschnitt des piezoelektrischen Substrats in der Umgebung der Rillen (2b) durch Entfernen eines Abschnitts des piezoelektrischen Substrats von der Seite der Hauptoberfläche (2a) des piezoelektrischen Substrats, um unter Verwendung des metallischen Films, welcher in den Rillen angeordnet ist, die IDT-Elektrode (6) und die Verdrahtungselektrode (5, 7) auszubilden, und
einen Schritt des Bondens des Abdeckelements (13) an der einen Hauptoberfläche (2a) des piezoelektrischen Substrats.

2. Verfahren zum Herstellen einer Oberflächenschallwellenvorrichtung nach Anspruch 1, wobei der Schritt des Ausbildens des vertieften Abschnitts (2d) durch Durchführen eines CMP-Prozesses von der Seite der einen Hauptoberfläche (2a) des piezoelektrischen Substrats durchgeführt wird.

3. Verfahren zum Herstellen einer Oberflächenschallwellenvorrichtung nach Anspruch 1, wobei der Schritt des Ausbildens des vertieften Abschnitts (21 c) durch Trockenätzen durchgeführt wird, während eine Maske (25) auf der einen Hauptoberfläche des piezoelektrischen Substrats angewandt wird.

4. Verfahren zum Herstellen einer Oberflächenschallwellenvorrichtung nach einem der Ansprüche 1 bis 3, wobei der Schritt des Bondens des Abdeckelements (13) an das piezoelektrische Substrat (2) durch Direktbonden durchgeführt wird.

5. Verfahren zum Herstellen einer Oberflächenschallwellenvorrichtung nach Anspruch 4, wobei, wenn das piezoelektrische Substrat (2) und das selement (13) direkt zusammen gebondet werden, eine hydrophile isolierende Dünnschicht auf der einen Hauptoberfläche des piezoelektrischen Substrats (2a) und/oder auf einer Oberfläche des Abdeckelements (13) ausgebildet wird, welches an das piezoelektrische Substrat gebondet werden soll.

6. Verfahren zum Herstellen einer Oberflächenschallwellenvorrichtung nach einem der Ansprüche 1 bis 5, ferner umfassend einen Schritt des Ausbildens einer Durchkontaktelektrode (9, 10) in dem piezoelektrischen Substrat, welche mit der Verdrahtungselektrode (5, 7) verbunden werden soll.

7. Verfahren zum Herstellen einer Oberflächenschallwellenvorrichtung nach einem der Ansprüche 1 bis 6, ferner umfassend einen Schritt des Ausbildens einer Durchkontaktelektrode in dem Abdeckelement (13), welche mit der Verdrahtungselektrode (5, 7) elektrisch verbunden werden soll.

8. Verfahren zum Herstellen einer Oberflächenschallwellenvorrichtung nach einem der Ansprüche 1 bis 7, wobei als das Abdeckelement ein piezoelektrisches Substrat (2) in einer Hauptoberfläche verwendet wird, aus welcher eine IDT-Elektrode (6) und eine Verdrahtungselektrode (5, 7) wie in dem Fall des piezoelektrischen Substrats ausgebildet werden.

9. Oberflächenschallwellenvorrichtung (1), umfassend:
ein piezoelektrisches Substrat (2) in einer Hauptoberfläche (2a), aus welcher ein vertiefter Abschnitt (2d) ausgebildet ist, und in welche eine Rille (2b) mit einer Form entsprechend einer Form einer IDT-Elektrode (6) in dem vertieften Abschnitt (2d) ausgebildet ist,
eine IDT-Elektrode (6), welche in die Rille (2b) eingebettet ist,
ein Abdeckelement (13), welches an die eine Hauptoberfläche (2a) des piezoelektrischen Substrats gebonded ist,
eine Durchkontaktelektrode (9, 10), welche in dem piezoelektrischen Substrat bereitgestellt ist und welche mit der IDT-Elektrode (6) elektrisch verbunden ist, und
eine Abschlußelektrode(11, 12), welche in dem piezoelektrischen Substrat bereitgestellt ist, welche mit der Durchkontaktelektrode (9, 10) elektrisch verbunden ist und welche so angeordnet ist, daß sie mit einer externen Vorrichtung elektrisch verbunden werden kann.

10. Oberflächenschallwellenvorrichtung nach Anspruch 9, wobei eine Rille (2c) mit einer Form entsprechend einer Form einer Verdrahtungselektrode (5, 7) in der einen Hauptoberfläche (2a) des piezoelektrischen Substrats an einer Position ausgebildet ist, welche von derjenigen des vertieften Abschnitts (2d) verschieden ist, und die Verdrahtungselektrode (5, 7) in die Rille (2c) eingebettet ist.

## Revendications

1. Procédé de fabrication d'un dispositif à ondes acoustiques de surface (1) comprenant :
une étape de préparation d'un substrat piézoélectrique (2) et d'un élément de couverture (13) ;
une étape de formation de rainures (2b, 2c), dans une surface principale (2a) du substrat piézoélectrique (2), dans des parties dans lesquelles une électrode IDT (6) et une électrode de câblage (5, 7) doivent être prévues ;
une étape de formation d'un film métallique (M), sur ladite surface principale (2a) du substrat piézoélectrique, au moins dans les rainures (2b, 2c) ;
une étape de formation d'une partie évidée (2d) sur le film métallique (M) situé dans les rainures (2b) et sur une partie du substrat piézoélectrique au voisinage des rainures (2b), par retrait d'une partie du substrat piézoélectrique depuis le côté surface principale (2a) du substrat piézoélectrique, pour former l'électrode IDT (6) et l'électrode de câblage (5, 7), au moyen du film métallique positionné dans les rainures ; et
une étape de collage de l'élément de couverture (13) à ladite surface principale (2a) du substrat piézoélectrique.

2. Procédé de fabrication d'un dispositif à ondes acoustiques de surface selon la revendication 1, dans lequel l'étape de formation de la partie évidée (2d) est réalisée par exécution d'une opération de CMP (polissage chimico-mécanique) sur ledit côté surface principale (2a) du substrat piézoélectrique.

3. Procédé de fabrication d'un dispositif à ondes acoustiques de surface selon la revendication 1, dans lequel l'étape de formation de la partie évidée (21c) est réalisée par gravure à sec alors qu'un masque (25) est appliqué sur ladite surface principale du substrat piézoélectrique.

4. Procédé de fabrication d'un dispositif à ondes acoustiques de surface selon l'une quelconque des revendications 1 à 3, dans lequel l'étape de collage de l'élément de couverture (13) au substrat piézoélectrique (2) est réalisée par collage direct.

5. Procédé de fabrication d'un dispositif à ondes acoustiques de surface selon la revendication 4, dans lequel, lorsque le substrat piézoélectrique (2) et l'élément de couverture (13) doivent être collés directement l'un à l'autre, un film mince isolant hydrophile est formé sur ladite surface principale du substrat piézoélectrique (2a) et/ou sur une surface de l'élément de couverture (13) qui doit être collée au substrat piézoélectrique.

6. Procédé de fabrication d'un dispositif à ondes acoustiques de surface selon l'une quelconque des revendications 1 à 5, comprenant en outre une étape de formation, dans le substrat piézoélectrique, d'une électrode traversante (9, 10) qui doit être connectée à l'électrode de câblage (5, 7).

7. Procédé de fabrication d'un dispositif à ondes acoustiques de surface selon l'une quelconque des revendications 1 à 6, comprenant en outre une étape de formation, dans l'élément de couverture (13), d'une électrode traversante qui doit être connectée électriquement à l'électrode de câblage (5, 7).

8. Procédé de fabrication d'un dispositif à ondes acoustiques de surface selon l'une quelconque des revendications 1 à 7, dans lequel il est utilisé, en tant qu'élément de couverture, un substrat piézoélectrique (2) dans une surface principale duquel sont formées une électrode IDT (6) et une électrode de câblage (5, 7), comme dans le cas du substrat piézoélectrique.

9. Dispositif à ondes acoustiques de surface (1) comprenant :
un substrat piézoélectrique (2) dans une surface principale (2a) duquel est formée une partie évidée (2d), et dans lequel une rainure (2b) ayant une forme correspondant à une forme d'une électrode IDT (6) est formée dans la partie évidée (2d) ;
une électrode IDT (6) enfouie dans la rainure (2b) ;
un élément de couverture (13) collé à ladite surface principale (2a) du substrat piézoélectrique ;
une électrode traversante (9, 10) qui est prévue dans le substrat piézoélectrique, et qui est connectée électriquement à l'électrode IDT (6) ; et
une électrode formant borne (11, 12) qui est prévue dans le substrat piézoélectrique, qui est connectée électriquement à l'électrode traversante (9, 10), et qui est disposée de façon à être connectée électriquement à un dispositif externe.

10. Dispositif à ondes acoustiques de surface selon la revendication 9, dans lequel une rainure (2c) ayant une forme correspondant à une forme d'une électrode de câblage (5, 7) est formée dans ladite surface principale (2a) du substrat piézoélectrique, à une position différente de celle de la partie évidée (2d), et l'électrode de câblage (5, 7) est enfouie dans la rainure (2c).
